# EUROPEAN PATENT APPLICATION

(11) **EP 4 646 042 A1**
(43) Date of publication of application: **05.11.2025**
(21) Application number: 25169947.6
(22) Date of filing: 11.04.2025
(51) Int. Cl.: H05K 5/06

(54) **VENT SEAL FOR EXTREME ENVIRONMENT APPLICATIONS**

(30) Priority: 30.04.2024 CN 202410537387
(71) Applicant: Suzhou Littelfuse OVS Co., Ltd., Suzhou Jiangsu 215021 (CN)
(72) Inventor: Li, Yuanxue, Suzhou, 215021 (CN); Pan, Shangchun, Suzhou, 215021 (CN); Liu, Renan, Suzhou, 215021 (CN)
(74) Representative: Arnold & Siedsma

(57) **Abstract**

Disclosed herein is a novel design of a vent seal for a sealed electronics component enclosure. The vent seal comprises a rubber element defining balloon portion which extends through an opening in the wall of the enclosure. The balloon portion expands into the interior of the enclosure when the air pressure outside of the enclosure rises and collapses when the pressure outside of the enclosure falls. The vent seal is also provided with an air router that allows the easy passage of air into the interior of the balloon portion, while inhibiting particulates from entering the interior of the balloon portion to prevent interference with the functioning of the vent seal.

## Description

### Background

Sealed electronic enclosures are essential for ensuring the safety and functionality of electronics under normal conditions and also in harsh or challenging environments. They are designed to protect electronic components from environmental factors such as dust, ashes, harmful (e.g., corrosive) gases and water, such as might be found, for example, in an engine compartment of a commercial vehicle. Such enclosures may be composed of various materials such as plastic, aluminum, and steel, and are used in a wide range of applications, from industrial settings to consumer electronics.

One consideration in the design of sealed electronic enclosures is the pressure differential between the inside of the enclosure and the exterior environment. A large enough pressure differential may cause damage to electronic components housed within the enclosure. For example, the electronic components may experience cracking or may explode if the pressure within the enclosure is too high. As a result, such enclosures are often provided with a vent that allows the equalization of the pressure between the inside of the enclosure and the outside environment.

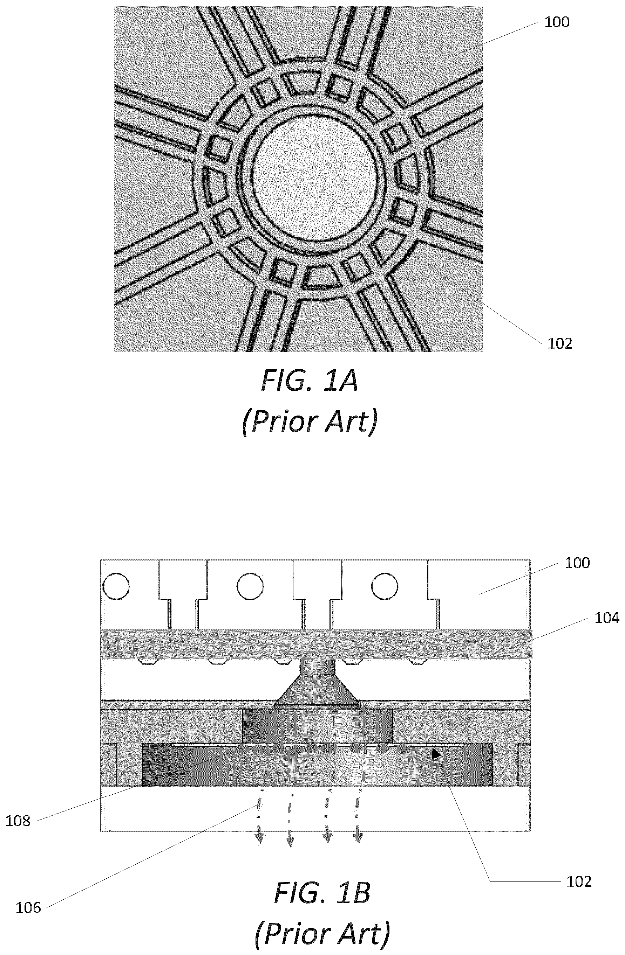

An example of such a prior art enclosure is shown in **FIGS. 1****(A-B).** **FIG. 1A** shows a close-up of the vent 102 *in situ* in a housing 100 of a sealed enclosure. Vent 102 may consist of a barrier mounted in housing 100. A cross-sectional view of the electronic enclosure is shown in **FIG. 1B** and shows an electronic circuit board 104 with mounted electronic components mounted thereon disposed within the interior of enclosure 100.

Many other designs of prior art vents exist but all suffer from the same deficiencies. The prior art designs allow harmful or corrosive gases to enter the interior of the enclosure and further allow the collection of particulates (e.g., fragments, dust or ashes) near the opening of the vent, which may block the vent. This is shown in **FIG. 1B** which shows harmful or corrosive gases 106 entering the interior of enclosure 100 via vent 102. Also shown are particulates (e.g., fragments, dust or ashes) 108 adhering to the surface of the barrier.

Therefore, it is desirable to provide a vent which allows the equalization of pressure between the interior of the enclosure and the exterior environment while preventing harmful or corrosive gases from entering the enclosure and further preventing particulates from blocking the vent.

### Summary of the Invention

This Summary is provided to introduce a selection of concepts in a simplified form that are further described below in the Detailed Description. This Summary is not intended to identify key features or essential features of the claimed subject matter, nor is it intended as an aid in determining the scope of the claimed subject matter.

Disclosed herein is a novel vent seal capable of equalizing the pressure between the interior of a sealed enclosure and the exterior environment without allowing harmful or corrosive gases to enter the interior of the enclosure and which further inhibits the collection of particulates near the vent seal. The vent seal preferably comprises a flexible barrier, impervious to the passage of gases or liquids therethrough, mounted in a wall of the enclosure having a balloon portion which extends through an opening into the interior of the enclosure. The barrier is capable of expanding or collapsing depending upon the differential in air pressure between the interior of the enclosure and the outside environment. The vent further comprises an air router that routes air in a circuitous fashion to the barrier and which is sized and shaped to inhibit the collection of particulates near the barrier.

The disclosure also includes the use of the vent seal for equalizing pressure between an interior and an exterior of the enclosure for preventing harmful or corrosive gases from entering the enclosure and for preferably preventing particulates from blocking the vent

### Brief Description of the Drawings

**FIGS. 1****(A-B)** show an exemplary prior art vent seal.
**FIG. 2A** shows an isometric view of an exemplary electronics component enclosure of the type with which the present invention would be used. **FIG. 2B** shows a cross-sectional view of the enclosure showing the vent seal of the present invention *in situ.*
**FIG. 3** is a close-up, cross-sectional view of the vent seal mounted in the wall of the enclosure.
**FIGS. 4****(A-B)** are an isometric and a cross-sectional view of the barrier, respectively.
**FIG. 5A** is a cross-sectional view of the vent seal showing operation of the air router. **FIG. 5B** is a cross-sectional isometric view of one embodiment of the air router.
**FIG. 6** is a cross-sectional view of the vent seal showing the condition in which the air pressure on the exterior of the enclosure is greater than the pressure on the interior of the enclosure.
**FIG. 7** is a cross-sectional view of the vent seal showing the condition in which the air pressure on the exterior of the enclosure is lower than the pressure on the interior of the enclosure.

### Detailed Description

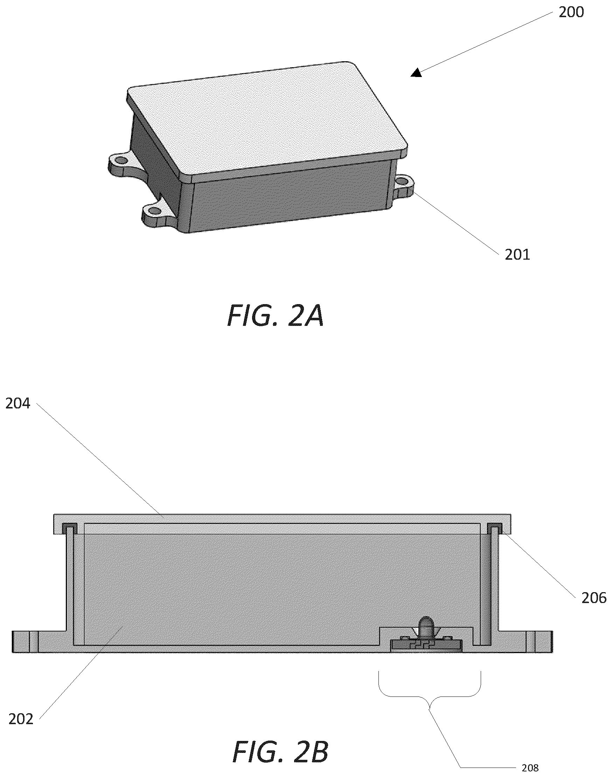

Disclosed herein is a novel design of a vent seal for use, in a sealed enclosure suitable for containing delicate electronic components in a harsh environment. The vent seal prevents the entry of harmful or corrosive gases into the interior of the enclosure and inhibits the collection of particulates around the opening of the vent seal. **FIG. 2A** is an isometric view of an exemplary enclosure 200 with which the vent seal of the present invention may be used. Enclosure 200 is designed to enclose electronic components and protect the electronic components from the outside environment when deployed in a harsh environment, for example, in an engine compartment of a commercial vehicle.

Enclosure 200 may be composed of a hard plastic material, for example, polyethylene, polycarbonate or any other rigid plastic material. Enclosure 200 may also be composed of other materials suitable for the purpose of protecting the electronic components in the harsh environment, for example, aluminum or steel. Enclosure 200 may be held in place in the environment via screws deployed through openings 201 or by any other known means.

**FIG. 2B** shows a cross-sectional view of enclosure 200. Enclosure 200 may comprise a housing 202 fitted with a cover 204 which may be held in place by any known means, for example, by screws or via a friction fit. Gasket 206 may be deployed between housing 202 and cover 204 to seal the enclosure and to prevent the entry of gases or liquids into the enclosure. The vent seal 208 of the present invention is shown deployed in a wall of housing 202 of enclosure 200.

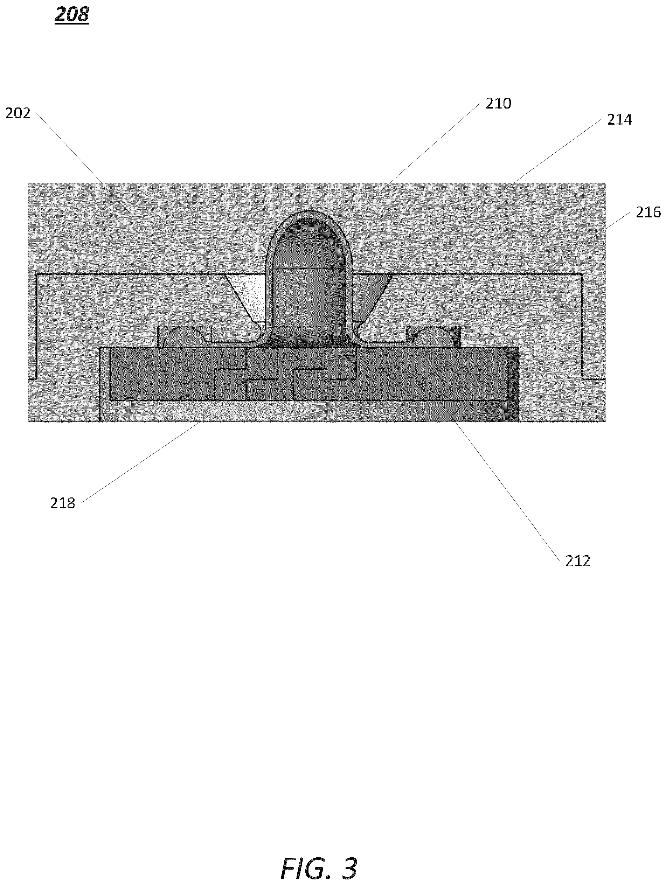

**FIG. 3** shows a cross-sectional view of vent seal 208 *in situ* in housing 202 of enclosure 200. Vent seal 208 comprises a barrier 210 and an air router 212. Vent seal 208 may be fitted within a recessed area 218 defined in housing 202 of enclosure 200. Housing 202 also defines a groove 216 defined therein to accept a sealing member. Groove 216 may be circular in shape and the sealing member may be an O-ring formed integrally with barrier 210. Housing 202 may further define an opening 217 for acceptance of a balloon portion of barrier 210 and a conical area 214 around the interior of opening 217 to accommodate expansion of the balloon portion of barrier 210. Note that the balloon portion of barrier 210 may be any shape and is only referred to herein as a "balloon" portion because it is capable of both expanding and collapsing.

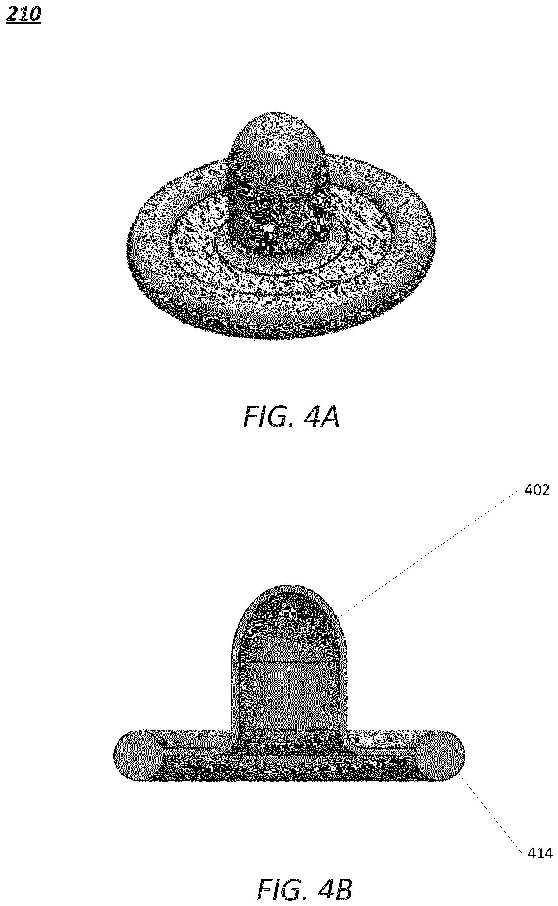

**FIGS. 4****(A-B)** show isometric and cross-sectional views of barrier 210 respectively. Barrier 210 consists of a balloon portion 402 which extends through the opening defined in housing 202. Barrier 210 further comprises an integral sealing element 412, which can be an O-ring, which is disposed in circular groove 216 defined in housing 202. Sealing element 412 may be formed separately from barrier 210. Barrier 210 can be composed of a flexible rubber material which allows expansion and contraction of the balloon portion 402 of barrier 210 and which blocks the passage of gasses therethrough.

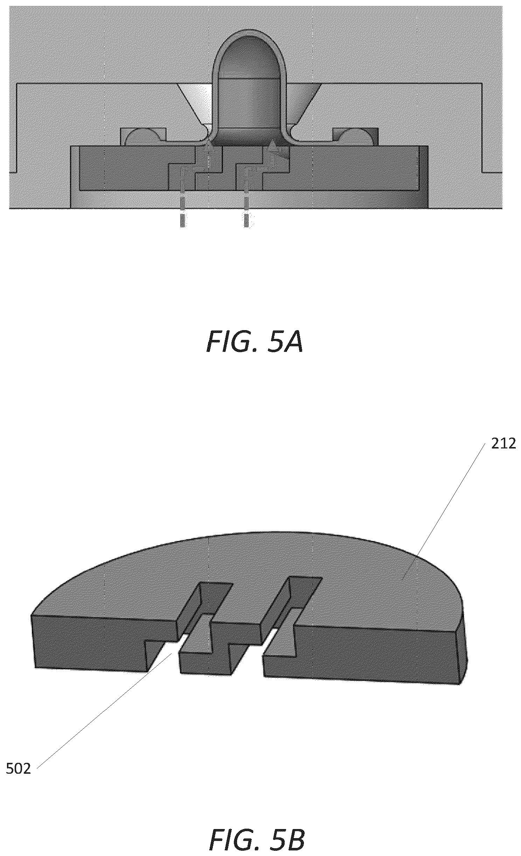

Barrier 210 is held in place by air router 212, shown in cross-sectional view as part of vent seal 208 and in an isolated, cross-sectional isometric view in **FIGS. 5****(A-B),** respectively. The purpose of air router 212 is two-fold. First, air router 212 holds barrier 210 in place and second, air router 212 provides a passage 502 therethrough that allows air to enter into or exit the interior cavity of balloon portion 402 of barrier 210, while also inhibiting particulates from entering the interior cavity of balloon portion 402. The integral sealing member 404 defined in barrier 210 is held within groove 216 by air router 212 and provides a seal between air router 212 and housing 202. As previously stated, sealing member 404 is preferably an O-ring having a circular cross-sectional shape.

Passage 502 defined in air router 212 comprises one or more openings sized and shaped to provide a circuitous route which easily allows the passage of air therethrough into the interior cavity of balloon portion 402, but which makes it difficult for particulates to enter the interior cavity of balloon portion 402, which would inhibit proper operation of vent seal 208. The particular zig-zag-shaped design of the circuitous route of passage 502 shown in **FIG. 5B** is only one of many possible embodiments of passage 502. The one or more openings of passage 502 may be sized and shaped to allow the passage of air therethrough while also inhibiting the passage of particulates is contemplated to be within the scope of the invention. Air router 212 may be composed of a hard plastic material similar to or identical to the material of which enclosure 200 is composed, and may be held in place by any known means, including, for example, by screws, hooks, friction fit, etc.

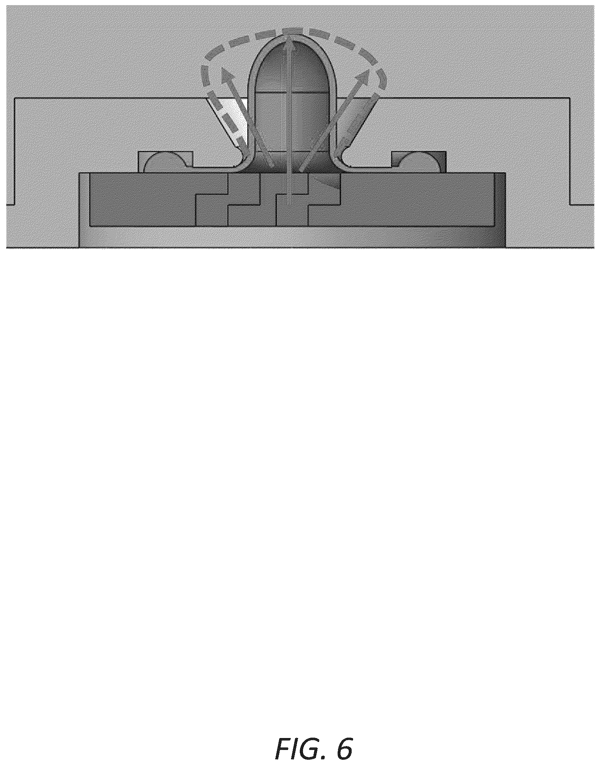

**FIG. 6** shows the operation of vent seal 208 in the condition wherein the air pressure of the outside environment is greater than the air pressure inside enclosure 200. Under such conditions, air is forced through passage 502 and into the interior cavity of balloon portion 402, which causes balloon portion 402 to expand as shown by the dashed line in **FIG. 6****.** The interior wall of housing 202 is preferably provided with a conical area 214 defined therein around opening 217 through which the balloon portion 402 extends to accommodate the expansion of balloon portion 402. The expansion of balloon portion 402 decreases the volume of the interior of housing 200 to equalize the pressure between the interior of housing 200 and the external environment.

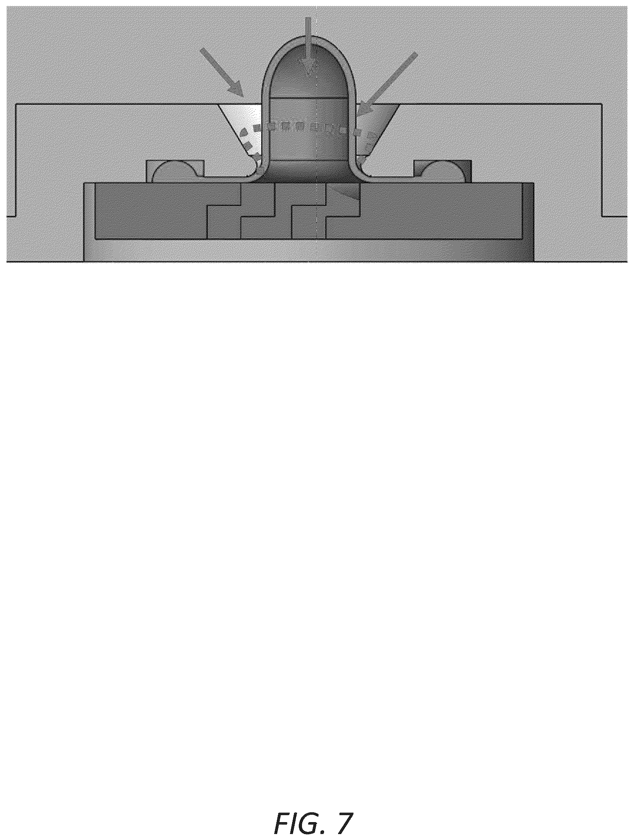

**FIG. 7** shows the operation of vent seal 208 in the condition wherein the air pressure of the outside environment is lower than the air pressure inside enclosure 200. Under such conditions, the higher pressure in the interior of enclosure 200 forces the collapse of balloon portion 402. Any air contained in the interior cavity of balloon portion 402 is thereby forced through passage 502 and into the outside environment. Balloon portion 402 may collapse into conical area 214 defined in housing 202, as shown by the dashed line in **FIG. 7****.**

As would be realized by one of skill in the art, many variations in the designs discussed herein fall within the intended scope of the invention. For example, the size of balloon portion 208 has not been specified and various sizes are contemplated be within the scope of the invention. Likewise, the materials of which the various parts of vent seal 208 are composed may vary.

## Claims

1. A vent seal disposed in a wall of a sealed enclosure, comprising:
a barrier defining a balloon portion and an integral sealing element, wherein the balloon portion extends through an opening in the wall of the sealed enclosure and wherein the sealing element is disposed within a groove defined in the wall of the sealed enclosure; and
an air router disposed within a recess defined in the wall of the sealed enclosure, the air router holding the sealing element within the groove, wherein the air router defines one or more openings comprising a circuitous route for the passage of air into an interior cavity of the balloon portion of the barrier.

2. The vent seal of claim 1, wherein the barrier is composed of flexible rubber.

3. The vent seal of claim 1 or 2, wherein the air router is composed of plastic.

4. The vent seal of any of the preceding claims, wherein the circuitous route for the passage of air inhibits the passage or particulates therethrough and into the interior cavity of the balloon portion.

5. The vent seal of any of the preceding claims, wherein the wall of the sealed enclosure defines a cut-out around the opening sized and shaped to accommodate expansion of the balloon portion.

6. The vent seal of claim 5, wherein the cut-out is conically shaped.

7. The vent seal of any of the preceding claims, wherein the sealing element is an O-ring and further wherein the groove is circular in shape and formed in the recess around an exterior of the opening through which the balloon portion extends.

8. The vent seal of any of the preceding claims, wherein the balloon portion expands into an interior of the enclosure when air pressure outside of the enclosure is greater than air pressure in the interior of the enclosure.

9. The vent seal of any of the preceding claims, wherein the balloon portion collapses when air pressure outside of the enclosure is lower than air pressure in the interior of the enclosure.

10. The vent seal of any of the preceding claims, wherein the circuitous route comprises one or more zig-zag-shaped openings.

11. The vent seal according to any of the preceding claims, wherein the enclosure is composed of a hard plastic material, for example, polyethylene, polycarbonate.

12. The vent seal according to any of the preceding claims 1-10, wherein the enclosure is composed of materials suitable for the purpose of protecting electronic components in the harsh environment, for example, aluminum or steel.

13. The vent seal according to any of the preceding claims, wherein the enclosure is a sealed enclosure, enclosing electronic components.

14. Use of a vent seal according to any of the preceding claims for equalizing pressure between an interior and an exterior of the enclosure and for preventing harmful or corrosive gases from entering the enclosure.

15. Use according to claim 14 for preventing particulates from blocking the vent
